# EUROPÄISCHE PATENTSCHRIFT

(11) **EP 0 967 720 B1**
(45) Veröffentlichungstag und Bekanntmachung des Hinweises auf die Patenterteilung: **05.07.2006**
(21) Anmeldenummer: 99109249.5
(22) Anmeldetag: 25.05.1999
(51) Int. Cl.: H03J 1/04

(54) **Verfahren und Einrichtung zum Betrieb eines Rundfunkgerätes**
Method and arrangement for operation of a radio receiver
Procédé et dispositif pour l' opération d' un récepteur radio

(30) Priorität: 04.09.1998 DE 19840461; 26.05.1998 DE 19823317
(43) Veröffentlichungstag der Anmeldung: 29.12.1999
(73) Patentinhaber: Volkswagen Aktiengesellschaft, 38436 Wolfsburg (DE)
(72) Erfinder: Kiesewetter, Thomas, 38118 Braunschweig (DE); Schönemann, Otto, 38444 Wolfsburg (DE); Hermann, Holger, Dipl.-Phys., 38165 Lehre (DE)

(56) Entgegenhaltungen:
- WO-A-96/04724
- FR-A- 2 644 019

## Beschreibung

Die Erfindung betrifft ein Verfahren sowie eine Einrichtung zum Betrieb eines Rundfunkempfängers in einem Kraftfahrzeug, bei welchem verschiedene Funktionstasten zum Anwählen von gespeicherten Sendern vorgesehen sind und ein elektronisches Display zur Anzeige der Sender, gemäß Oberbegriff der Patentansprüche 1 und 10.

Verfahren und Einrichtungen dieser Art sind im Hinblick auf die Realisierung möglichst effizient arbeitender und anzeigender Auto-Audio-Anlagen bekannt. So ist beispielsweise aus der DE 38 44 929 C 2 eine Umschaltung der Senderkennung auf die Frequenz bekannt, die zur Kenntlichmachung dient, daß ein Senderpegel unterhalb eines Mindestpegels abgesunken ist. D. h., der Fahrzeugführer, der nunmehr bemerkt, daß die übliche Senderkennung auf die Anzeige der zugehörigen Frequenz wechselt, soll hierdurch einen Hinweis erhalten, daß der Mindestpegel für einen Empfang unterschritten ist. Sodann kann der Fahrzeugführer den Sender nacheinstellen oder wechseln. Nachteilig ist hierbei, daß zum einen der Fahrzeugführer eine besondere Aufmerksamkeit der Anzeige und der nachträglichen Nachstellung zuwenden muß, was ihn wiederum vom Verkehrsgeschehen ablenkt und somit zu erhöhtem Risiko führt.

Aus der DE 195 10 219 A 1 ist eine Aufzeichnungseinheit bekannt, welche Verkehrsfunksendungen aufzeichnet und später abrufbar macht. Eine solche Einrichtung ist lediglich dafür geeignet, Verkehrsfunksendungen zu unterdrücken, oder zu verhindern, daß dieselben gänzlich verlorengehen. Nachteilig ist hierbei, daß die so später abgehörte Verkehrsfunksendung natürlich dann nicht mehr dem aktuellen Verkehrsgeschehen entspricht.

Die WO 97/06612 bzw. die dazugehörige DE 195 29 075 A 1 zeigt eine Einrichtung, bei welcher zuerst die Sender oder ein Sender auf übliche Weise elektronisch aufgefunden wird, und daß sodann zunächst die Programmart und zeitverzögert dazu der Sendername bzw. die Senderkennung angezeigt wird. Wahlweise kann dies im Wechsel auch nachfolgend angezeigt werden.

Die WO 96/04724 A1 offenbart einen Radioempfänger mit Funktionstasten zum Anwählen von Sendern und einem elektronischen Display zur Anzeige der Sender auf einer analogen Frequenzskala.

Der Erfindung liegt die Aufgabe zugrunde, ein Verfahren sowie eine Einrichtung der gattungsgemäßen Art dahingehend weiterzubilden, daß der Fahrzeugführer eine größere Übersicht über die einstell- und abrufbaren Sender hat. Eine weitere Aufgabe besteht darin, dem Fahrzeugführer die Aufgabe des Suchens oder des Nachstellens eines pegelstarken Verkehrsfunksenders abzunehmen.

Die gestellte Aufgabe bzw. gestellten Aufgaben werden hinsichtlich eines Verfahrens der gattungsgemäßen Art erfindungsgemäß durch die kennzeichnenden Merkmale des Patentanspruches 1 gelöst.

Weitere vorteilhafte Ausgestaltungen der Erfindung hinsichtlich des Verfahrens sind in den abhängigen Ansprüchen 2 bis 9 angegeben.

Hinsichtlich einer gattungsgemäßen Einrichtung ist die gestellte Aufgabe erfindungsgemäß durch die kennzeichnenden Merkmale des Patentanspruches 10 gelöst.

Weitere vorteilhafte Ausgestaltung der erfindungsgemäßen Einrichtung sind in den übrigen abhängigen Ansprüchen angegeben.

Der Kemgedanke bei der Erfindung liegt darin, dem Fahrzeugführer nach Einschalten des Runkfunkgerätes zunächst die gesamte Bandbreite entlang aufsteigend dargestellter Frequenzzahlen an einer Linie zu geben, was einer besseren Übersicht dient. Desweiteren werden die darin verfügbaren pegelstarken Senderfrequenzen markiert angezeigt, und in einem nachfolgenden, zeitlich begrenzten oder auch zeitlich unbegrenzten Abschnitt dann die den Funktions- bzw. Stationsstasten zugewiesenen Senderkennungen angezeigt. Grundsätzlich soll diese temporäre Umschaltung auf die analoge Darstellung der Frequenzskala nicht nur beim Einschalten des Gerätes erscheinen sondern sie erfolgt auch, wenn durch Betätigen eines Betätigungsknopfes durch Drehen oder Tippen ein manueller Sendersuchlauf ausgelöst wird. Für diesen Augenblick schaltet das Display also auf eine traditionelle, quasi nostalgische Sender- bzw. Frequenzskala um, und ein Markierungselement wandert gemäß der besagten Betätigung nun wie beim alten Radio bekannt entlang der Frequenzlinie.

Hierdurch hat der Fahrzeugführer selbsttätig, also von ihm unbeeinflußt ablaufend, eine überblickende weitreichende Information über das verfügbare Senderangebot. Nach Abschluß dieses Vorganges kehrt die Anzeige dann bspw. wieder auf eine normale digitale Anzeige zurück.

Es ergeben sich somit beeinflußbare Zeitabschnitte in denen die Displayanzeige unterschiedlich ist.

In weiterer vorteilhafter Ausgestaltung des erfindungsgemäßen Verfahrens ist in einem anderen Teilbereich des Displays sowohl in dem ersten Zeitabschnitt bzw. Zeittakt sowie auch danach, der aktuell bzw. zuletzt eingestellte und somit nach Einschalten bereits hörbare Sender hinsichtlich seiner Senderkennung und seiner Frequenz gesondert angezeigt.

Wahlweise kann hierbei noch zusätzlich der zuletzt empfangene oder der pegelstärkste Verkehrsfunksender hinsichtlich Frequenz und Senderkennung angezeigt werden, auch wenn dieser zur Zeit nicht gehört wird.

Der Fahrzeugführer muß beim Radioempfang mittels eines erfindungsgemäßen Radioempfängers nicht auf die aktuelle Einstellung eines Verkehrsfunksenders achten, wenn er zusätzlich Verkehrsfunksendungen hören möchte. Die besagte Stummschaltung ist bereits bei parallelem Betrieb von CD oder Musikcassette bekannt. Jedoch ist die Stummschaltung eines weiteren, nicht verkehrsfunkgebundenen Senders, hierbei neu und macht den Fahrzeugführer in seiner Auswahl des gewünschten Senders völlig unabhängig.

Hinsichtlich der Einrichtung, welche mit Display und Funktionstasten sowie mit einem Tuner versehen ist, ist erfindungsgemäß vorgegeben, daß sich das Display zur Anzeigbarkeit einer Bandbreitenlinie längs erstreckt und die Funktionstasten neben oder unter dem Display plaziert sind, und daß das Display in einen oberen und einen unteren Anzeigenteilbereich segmentiert ist. Dabei ist darauf zu achten, daß die Funktionstasten sich entlang des Displays erstrecken, so daß in der weiteren vorteilhaften Ausgestaltung der Erfindung jede Funktionstaste in unmittelbarer Nähe desjenigen Displayabschnittes plaziert ist, welcher der Funktionstaste benachbart ist, so daß auch die zugewiesene Senderkennung angezeigt werden kann. Dadurch ist die Auswahl eines Senders für den Fahrzeugführer kein Ratespiel mehr sondern die Funktionstasten sind in den jeweiligen Displayabschnitte sozusagen beschriftet. Dies erhöht zum anderen auch die Sicherheit, weil der Fahrzeugführer damit weniger abgelenkt wird.

In vorteilhafter Ausgestaltung der einrichtungsgemäßen Erfindung kann die Einrichtung über einen zweiten einem Tuner verfügen, so daß zum einen das Sendertuning von gewünschten verfügbaren pegelstarken Sendern unabhängig ist vom Tuning von Verkehrsfunksendern. Dieser Betriebsmodus könnte jedoch auch mit nur einem einem Tuner betrieben werden.

Die Erfindung ist in der Zeichnung dargestellt und nachfolgend näher beschrieben.

Es zeigt:
- Figur 1: Erfindungsgemäßes Display mit Funktionstasten.
- Figur 2: Display mit Funktionstastenanordnung in einer Zeitphase etwa 10 Sekunden nach Drehen oder Betätigen des Betätigungsknopfes.

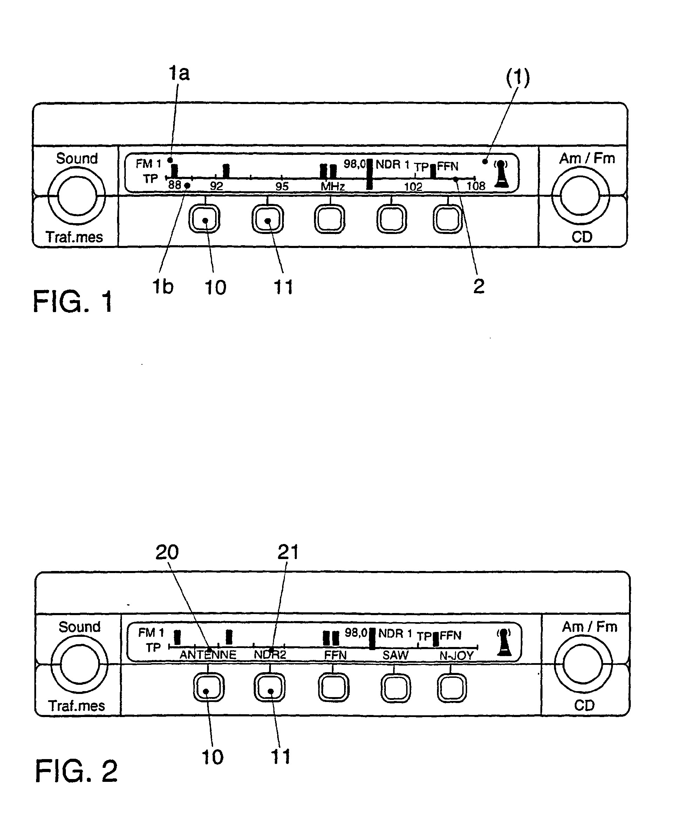

Figur 1 zeigt eine Momentaufnahme des Displays 1 innerhalb bzw. nach fünf Sekunden gerechnet vom Zeitpunkt des Betätigens des Betätigungsknopfes durch Drehen oder Tippen. Das längserstreckte Display 1 stellt, wie hier ersichtlich ist, eine Linie 2 dar, entlang der mit aufsteigendem Wert die Frequenzzahlen sich aneinanderfügen.

Die hier gewählte Darstellung ist beispielhaft aber nicht zwingend. Bei dieser Darstellung ist der verfügbare Frequenzbereich kenntlich gemacht. Oberhalb der Linie , d.h. im oberen Displayteil 1a sind durch das Display bereits Balken markiert, die pegelstarke Sender jedoch noch ohne weitere Angabe markieren. Lediglich der Balken des zuletzt eingestellten und gehörten Senders, hier beispielsweise NDR 1, ist mit seiner Senderkennung und seiner Frequenz von 98,0 Megahertz angezeigt. Desweiteren ist durch einen weiteren Balken der zuletzt eingestellte und möglicherweise noch immer pegelstarke Verkehrsfunksender mit den Angaben FFN für die Senderkennung und TP für den Hinweis als Verkehrsfunksender dargestellt.

Figur 2 zeigt das Display in einer Zeitphase, die sich nach der Einstellung gemäß Fig. 1 anschließt, also der Wechsel findet automatisch statt. Der die Bandbreite darstellende Strahl bzw. die Linie 2 enthält nun nicht mehr die Frequenzzahlen, sondern unterhalb der Linie, d.h. im unteren Displayteil 1b werden die Senderkennungen 20, 21, ... markiert, die den jeweiligen Funktionstasten als pegelstärkste Sender zugeordnet sind. Dabei ist die Anzeige der jeweiligen Senderkennung unmittelbar neben, d.h. oberhalb der entsprechenden Funktionstaste 10, 11, ... angeordnet, so daß die Funktionstaste somit als quasi beschriftet zu sehen ist. Oberhalb der besagten Linie sind nach wie vor die Balken für die entsprechend pegelstarken Sender, damit ungefähr abgeschätzt werden kann, in welchem Bereich des Frequenzbandes dieselben zu finden sind. Ebenfalls sichtbar ist im oberen Bereich der aktuell eingestellte Sender, hier NDR 1 mit 98,0 Megahertz sowie der letztgewählte bzw. der aktive Verkehrsfunksender FFN mit der Kennzeichnung TP für Verkehrsfunk.

Grundsätzlich gilt also, daß in erfindungsgemäßer Weise eine Betätigung des besagten Betätigungsknopfes bewirkt, daß das Display auf die weiter oben beschriebene analoge Darstellung umschaltet, und eine analoge Frequenzskala anzeigt solange die Betätigung des Frequenzsuchens, also des manuellen Suchens entlang der Senderskala andauert. Nach einer entsprechenden Zeit, die etwa 5 oder auch 10 Sekunden nach der letzten Betätigung betragen kann kehrt die Anzeige auf dem Display dann wieder auf die Ursprungsdarstellung zurück.

Vorteilhafterweise ist im übrigen auch, daß der Verkehrsfunksender unabhängig vom aktuell zu hörenden Sender aufrecht erhalten wird und bei Verkehrsmitteilung durch Stummschaltung des aktuellen Senders denselben überlagert, ist es zweckmäßig, innerhalb der Einrichtung einen zweiten Tuner vorzusehen, so daß beide Funktionen völlig unabhängig voneinander betreibbar sind.

## Patentansprüche

1. Verfahren zum Betrieb eines Rundfunkempfängers in einem Kraftfahrzeug, bei welchem verschiedene Funktionstasten (10, 11) zum Anwählen von gespeicherten Sendern vorgesehen sind und ein elektronisches Display (1) zur Anzeige der Sender, wobei bei der Senderwahl durch Drehen oder Drücken eines Betätigungselementes ausgelöst eine Displayanzeige derart erfolgt, daß eine analoge Frequenzskala dargestellt wird, **dadurch gekennzeichnet,**
**daß** der jeweils für das Sende- bzw. Empfangsgebiet pegelstärkste Verkehrsfunksender automatisch eingestellt bzw. nachgestellt, gespeichert und zur Anzeige gebracht wind, wobei der jeweils pegelstärkste Verkehrsfunksender derart abgelegt und aktuell aufschaltbar ist, daß bei Hören eines Senders ohne Verkehrsfunk bei Empfang einer Verkehrsmitteilung über den Verkehrsfunksender der aktuell hörbare Sender für die Dauer der Verkehrsmitteilung stumm geschaltet wird.

2. Verfahren zum Betrieb eines Rundfunkgerätes nach Anspruch 1, **dadurch gekennzeichnet,**
**daß** die analoge Darstellung der Frequenzskala auch die aktuelle Position im Frequenzband anzeigt und ggf. auch die vorhandene Senderkerinung an der durch Drehen oder Drücken des besagten Betätigungsknopfes wandernden aktuellen Position dargestellt wird.

3. Verfahren zum Betrieb eines Rundfunkgerätes nach Anspruch 2, **dadurch gekennzeichnet,**
**daß** die empfangbaren Radiostationen an ihren Positionen im Frequenzband durch Markierungen dargestellt sind.

4. Verfahren zum Betrieb eines Rundfunkgerätes nach Anspruch 3, **dadurch gekennzeichnet, daß** an den Markierungen die Sender-Namen und ggf. die Frequenz dargestellt wird.

5. Verfahren zum Betrieb eines Rundfunkgerätes nach einem oder mehreren der vorhergehenden Ansprüche,
**dadurch gekennzeichnet,**
**daß** die dargestellten Radiostationen nur dann dargestellt werden, wenn ein einstellbarer Mindestpegel überschritten ist.

6. Verfahren zum Betrieb eines Rundfunkgerätes nach Anspruch 5,
**dadurch gekennzeichnet,**
**daß** die geometrische Form oder die Farbe der Markierung proportional abhängig vom jeweiligen Pegel geändert wird.

7. Verfahren zum Betrieb eines Rundfunkgerätes nach einem oder mehreren der vorhergehenden Ansprüche,
**dadurch gekennzeichnet,**
**daß** bei aktivem Verkehrsfunk der zuletzt angewählte Verkehrsfunk-Sender aktiv bleibt und entsprechend markiert wird.

8. Verfahren zum Betrieb eines Rundfunkgerätes nach einem oder mehreren der vorhergehenden Ansprüche,
**dadurch gekennzeichnet,**
**daß** nach Drehen oder Betätigen des Betätigungselementes nach einer vorgebbaren Zeit die Displayanzeige wieder auf die Darstellung der aktuellen Stationsbelegung der einzelnen Stationstasten zurückkehrt.

9. Verfahren zum Betrieb eines Rundfunkgerätes nach einem oder mehreren der vorhergehenden Ansprüche,
**dadurch gekennzeichnet,**
**daß** die analoge Skala auch beim automatischen Scannen das Frequenzband darstellt.

10. Einrichtung zum Betrieb eines Rundfunkgerätes in einem Kraftfahrzeug, bei welchem verschiedene Funktionstasten (10, 11) zum Anwählen von gespeicherten Sendern vorgesehen sind und ein Display (1) sowie Funktionstasten (10, 11) zum Abrufen der gespeicherten Sender, sowie einem Tuner, wobei das Display (1) zur Anzeigbarkeit einer Bandbreitenlinie bzw. einer Frequenzlinie oder -skala längs erstreckt ist und die Funktionstasten (10, 11) neben oder unter dem Display (1) plaziert sind, und wobei das Display (1) in einen oberen und einen unteren Anzeigenteilbereich segmentiert ist, **dadurch gekennzeichnet,**
**daß** der jeweils für das Sende- bzw. Empfangsgebiet pegelstärkste Verkehrsfunksender automatisch einstellbar bzw. nachstellbar, speicherbar und anzeigbar ist, wobei der jeweils pegelstärkste Verkehrsfunksender derart abgelegt und aktuell aufschaltbar ist, daß bei Hören eines Senders ohne Verkehrsfunk bei Empfang einer Verkehrsmitteilung über den Verkehrsfunkserider der aktuell hörbare Sender für die Dauer der Verkehrsmitteilung stumm geschaltet wird.

11. Einrichtung zum Betrieb eines Rundfunkgerätes nach Anspruch 10,
**dadurch gekennzeichnet,**
**daß** die Funktionstasten (10, 11) jeweils in unmittelbarer Nähe desjenigen Displayabschnittes angeordnet sind, in welchem auch die den Funktionstasten (10, 11) zugewiesenen Senderkennungen angezeigt werden.

12. Einrichtung zum Betrieb eines Rundfunkgerätes nach Anspruch 10 oder 11,
**dadurch gekennzeichnet,**
**daß** die besagte Einrichtung über mindestens zwei Tuner verfügt.

## Claims

1. Method for operating a broadcast radio receiver in a motor vehicle, in which various function keys (10, 11) for selecting stored stations and an electronic display (1) for displaying the stations are provided, where, during station selection, rotating or pressing an operating element triggers a readout on the display such that an analogue frequency scale is shown,
**characterized**
**in that** the respective traffic radio station with the strongest level for the transmission and reception area is automatically set or readjusted, stored and displayed, with the respective traffic radio station with the strongest level being stored and being able to break in such that, when listening to a station without traffic radio and a traffic message is received via the traffic radio station the station, which can currently be heard is muted for the duration of the traffic message.

2. Method for operating a broadcast radio according to Claim 1, **characterized in that** the analogue representation of the frequency scale also indicates the current position in a frequency band, and possibly also the present station identifier is shown at the current position, which moves when said operating knob is rotated or pressed.

3. Method for operating a broadcast radio according to Claim 2, **characterized in that** the receivable radio stations are shown at their positions in a frequency band by markers.

4. Method for operating a broadcast radio according to Claim 3, **characterized in that** the station names and possibly the frequency is/are shown at the markers.

5. Method for operating a broadcast radio according to one or more of the preceding claims,
**characterized**
**in that** the radio stations shown are shown only if a settable minimum level is exceeded.

6. Method for operating a broadcast radio according to Claim 5,
**characterized**
**in that** the geometrical shape or the colour of the marker is changed in proportional dependence on the respective level.

7. Method for operating a broadcast radio according to one or more of the preceding claims,
**characterized**
**in that** when traffic radio is active the last traffic radio station selected remains active and is marked accordingly.

8. Method for operating a broadcast radio according to one or more of the preceding claims,
**characterized**
**in that** when the operating element has been rotated or operated the readout on the display returns to showing the current station assignment of the individual station keys after a prescribable time.

9. Method for operating a broadcast radio according to one or more of the preceding claims,
**characterized**
**in that** the analogue scale shows the frequency band during automatic scanning too.

10. Device for operating a broadcast radio in a motor vehicle, in which various function keys (10, 11) for selecting stored stations and a display (1) and also function keys (10, 11) for retrieving the stored stations, and also a tuner, are provided, where the display (1) is elongate in order to be able to display a bandwidth line or a frequency line or scale, and the function keys (10, 11) are placed next to or below the display (1), and where the display (1) is segmented into an upper and a lower display subregion,
**characterized**
**in that** the respective traffic radio station with the strongest level for the transmission and reception area can be automatically set or readjusted, stored and displayed, with the respective traffic radio station with the strongest level being stored and being able to break in such that, when listening to a station without traffic radio and a traffic message is received via the traffic radio station, the station which can currently be heard is muted for the duration of the traffic message.

11. Device for operating a broadcast radio according to Claim 10,
**characterized**
**in that** the function keys (10, 11) are respectively arranged in immediate proximity to that display portion in which the station identifiers associated with the function keys (10, 11) are also displayed.

12. Device for operating a broadcast radio according to Claim 10 or 11,
**characterized**
**in that** said device has at least two tuners.

## Revendications

1. Procédé pour faire fonctionner un récepteur de radiodiffusion dans un véhicule automobile avec lequel sont prévues différentes touches de fonction (10, 11) pour sélectionner des émetteurs mémorisés et un écran électronique (1) pour afficher l'émetteur, un affichage sur l'écran déclenché lors de la sélection de l'émetteur par rotation ou pression d'un élément de commande s'effectuant de manière à représenter une graduation dés fréquences analogique, **caractérisé en ce que** l'émetteur de radiodiffusion d'informations de trafic ayant le niveau le plus puissant pour la zone d'émission ou de réception est réglé ou rajusté, mémorisé puis affiché automatiquement, l'émetteur de radiodiffusion d'informations de trafic ayant à chaque fois le niveau le plus puissant pouvant être mémorisé et momentanément activé de telle sorte que lors de l'audition d'un émetteur sans radiodiffusion d'informations de trafic, en cas de réception d'un communiqué d'informations de trafic par le biais de l'émetteur de radiodiffusion d'informations de trafic, l'émetteur actuellement audible est rendu silencieux pendant la durée du communiqué des informations de trafic.

2. Procédé pour faire fonctionner un appareil de radiodiffusion selon la revendication 1, **caractérisé en ce que** la représentation analogique de la graduation des fréquences indique également la position actuelle dans la bande de fréquences et éventuellement aussi l'identifiant de l'émetteur présent à la position actuelle réglable par rotation ou pression dudit bouton de commande.

3. Procédé pour faire fonctionner un appareil de radiodiffusion selon la revendication 2, **caractérisé en ce que** les stations radio pouvant être reçues sont représentées par des marquages au niveau de leurs positions dans la bande de fréquences.

4. Procédé pour faire fonctionner un appareil de radiodiffusion selon la revendication 3, **caractérisé en ce que** le nom de l'émetteur et éventuellement sa fréquence sont représentés au niveau des marquages.

5. Procédé pour faire fonctionner un appareil de radiodiffusion selon une ou plusieurs des revendications précédentes, **caractérisé en ce que** les stations radio représentées ne sont représentées que si un niveau minimum réglable est dépassé.

6. Procédé pour faire fonctionner un appareil de radiodiffusion selon la revendication 5, **caractérisé en ce que** la forme géométrique ou la couleur du marquage est modifiée proportionnellement en fonction du niveau correspondant.

7. Procédé pour faire fonctionner un appareil de radiodiffusion selon une ou plusieurs des revendications précédentes, **caractérisé en ce que** lors d'une radiodiffusion d'informations de trafic active, le dernier émetteur de.radiodiffusion d'informations de trafic sélectionné reste actif et il est marqué en conséquence.

8. Procédé pour faire fonctionner un appareil de radiodiffusion selon une ou plusieurs des revendications précédentes, **caractérisé en ce qu'**après avoir tourné ou actionné l'élément de commande, après un temps pouvant être prédéfini, l'affichage sur l'écran revient de nouveau à la représentation de l'affectation de station actuelle de chacune des touches de sélection de station.

9. Procédé pour faire fonctionner un appareil de radiodiffusion selon une ou plusieurs des revendications précédentes, **caractérisé en ce que** la graduation analogique représente également la bande de fréquences lors d'un balayage automatique.

10. Dispositif pour faire fonctionner un récepteur de radiodiffusion dans un véhicule automobile avec lequel sont prévues différentes touches de fonction (10, 11) pour sélectionner des émetteurs mémorisés et un écran (1) ainsi que des touches de fonction (10, 11) pour appeler les émetteurs mémorisés, ainsi qu'un tuner, l'écran (1) étant étendu en longueur pour pouvoir être capable d'afficher une ligne de bandes passante ou encore une ligne ou une graduation de fréquences et les touches de fonction (10, 11) étant placées à côté ou au-dessous de l'ecran (1), et l'écran (1) étant segmenté en une zone partielle d'affichage supérieure et inférieure, **caractérisé en ce que** l'émetteur de radiodiffusion d'informations de trafic ayant le niveau le plus puissant pour la zone d'émission ou de réception peut être réglé ou rajusté, mémorisé puis affiché automatiquement, l'émetteur de radiodiffusion d'informations de trafic ayant à chaque fois le niveau le plus puissant pouvant être mémorisé et momentanément activé de telle sorte que lors de l'audition d'un émetteur sans radiodiffusion d'informations de trafic, en cas de réception d'un communiqué d'informations de trafic par le biais de l'émetteur de radiodiffusion d'informations de trafic, l'émetteur actuellement audible est rendu silencieux pendant la durée du communiqué des informations de trafic.

11. Dispositif pour faire fonctionner un récepteur de radiodiffusion selon la revendication 10, **caractérisé en ce que** les touches de fonction (10, 11) sont à chaque fois disposées à proximité immédiate de la section de l'écran dans laquelle sont également affichées les identifiants d'émetteur affectés aux touches de fonction (10, 11).

12. Dispositif pour faire fonctionner un récepteur de radiodiffusion selon la revendication 10 ou 11, **caractérisé en ce que** ledit dispositif dispose d'au moins deux tuners.
